Europäisches Patentamt

European Patent Office

Office européen des brevets

(19)

(11) Numéro de publication: **0 156 722**
**B1**

(12) **FASCICULE DE BREVET EUROPEEN**

(45) Date de publication du fascicule du brevet: 20.06.90

(51) Int. Cl.⁵: **G 11 C 11/24**

(21) Numéro de dépôt: 85400474.4

(22) Date de dépôt: 12.03.85

(54) **Système à microprocesseur et mémoire vive dynamique avec rafraîchissement par logiciel, application à un enregistreur de perturbations.**

(30) Priorité: 16.03.84 FR 8404105

(43) Date de publication de la demande:
02.10.85 Bulletin 85/40

(45) Mention de la délivrance du brevet:
20.06.90 Bulletin 90/25

(84) Etats contractants désignés:
AT BE CH DE GB IT LI LU NL SE

(56) Documents cités:
EP-A-0 094 042
US-A-4 204 254

IBM TECHNICAL DISCLOSURE BULLETIN, vol.
24, no. 10, mars 1982, pages 4983-4984, New
York, US; C.E. BOYD et al.: "Software/hardware
approach to dynamic memory refresh"

(73) Titulaire: **Artus, Société Anonyme**
**Chemin du Champ des Martyrs**
**F-49240 Avrille (FR)**

(72) Inventeur: **Pastre, Jean-Luc**
**THOMSON-CSF SCPI 173, bld Haussmann**
**F-75379 Paris Cedex 08 (FR)**

(74) Mandataire: **Thévenet, Jean-Bruno et al**
**Cabinet BEAU DE LOMENIE 55 rue d'Amsterdam**
**F-75008 Paris (FR)**

Courier Press, Leamington Spa, England.

**Description**

L'invention concerne les systèmes informatiques utilisant un ou plusieurs microprocesseurs ayant accès à au moins une mémoire vive dynamique. Elle concerne plus particulièrement le rafraîchissement de la mémoire dynamique. Une application de l'invention se rapporte à un appareil de surveillance tel qu'un enregistreur de perturbations.

Un système microprocesseur est constitué classiquement d'une unité centrale ou microprocesseur, d'un générateur d'horloge, des circuits d'entrée/sortie, d'au moins une mémoire morte contenant le programme du système et d'au moins une mémoire vive pour stocker les données.

Ces différents circuits sont interconnectés par un bus d'adresses, un bus de données et un bus de contrôle.

La mémoire vive peut être du type statique ou dynamique. Dans le premier cas, la cellule d'information élémentaire est une bascule à transistors. Dans le deuxième cas, la cellule est un condensateur. A capacité égale, les mémoires dynamiques coûtent moins cher et prennent moins de place que les mémoires statiques. Elles ont cependant l'inconvénient de nécessiter une opération de rafraîchissement destinée à recharger cycliquement les condensateurs. De plus, ces mémoires sont le plus souvent à adressage multiplexé.

Les cellules de la mémoire sont classées par rangées et par colonnes.

Pour effectuer l'opération de rafraîchissement, il faut appliquer une adresse de rangée et fournir une impulsion négative sur l'entrée d'adresse de rangée, l'entrée d'adresse de colonne restant au niveau inactif: dans ce cas, toutes les cellules de la rangée adressée sont simultanément rafraîchies.

L'utilisation correcte des mémoires dynamiques nécessite un ensemble de circuits auxiliaires comprenant principalement un multiplexeur d'adresse, un compteur de rafraîchissement et un système d'arbitrage, c'est-à-dire plusieurs circuits intégrés plus ou moins complexes.

Une autre solution consiste à utiliser un circuit intégré dit "contrôleur de mémoire dynamique", mais c'est une solution assez onéreuse.

Différents dispositifs ont été imaginés pour éconmiser les circuits de rafraîchissement. On peut par exemple utiliser un circuit appelé "contrôleur d'accès direct mémoire".

Le document IBM Technical Disclosure Bulletin, vol. 24, no. 10, Mars 1982, pages 4983—4984, décrit un système simplifié dans lequel chaque rafraîchissement est déclenché périodiquement par un temporisateur relié à une entrée d'interruption du microprocesseur, et où une même adresse, fournie par le microprocesseur, est utilisée simultanément pour effectuer un rafraîchissement dans la mémoire vive et pour effectuer une lecture dans la mémoire morte. Cette dernière contient les programmes à exécuter. Lors d'une interruption pour rafraîchissement, le microprocesseur exécute un programme de rafraîchissement, qui est très simple et qui consiste essentiellement à lire un nombre fixé de cellules mémoires dans la mémoire morte. Les adresses de ces cellules sont appliquées à un décodeur qui fournit simultanément des signaux de commande à la mémoire morte et à la mémoire vive. Dans ce dispositif, il n'y a donc pas de compteur spécialisé pour le rafraîchissement, c'est le compteur ordinal du microprocesseur qui joue ce rôle. Par contre, il est nécessaire de prévoir un temporisateur pour lancer périodiquement un programme de rafraîchissement in interrompant le programme principal.

Le but de l'invention est de proposer un système encore plus simple, ne nécessitant pas de temporisateur et n'interrompant pas le programme principal.

Une particularité de l'invention consiste à utiliser le caractère périodique du logiciel du microprocesseur ainsi que le compteur ordinal de ce dernier.

On propose plus précisément un système informatique comportant au moins, un microprocesseur avec un compteur ordinal pour l'adressage d'une mémoire morte contenant le programme, une mémoire vive du type dynamique nécessitant des rafraîchissements, et un multiplexeur des adresses de ladite mémoire vive, les adresses de rafraîchissement étant issues du compteur ordinal et appliquées à la mémoire vive dynamique, par l'intermédiaire du multiplexeur, caractérisé en ce que le programme comporte une suite de codes d'instruction correspondant à une suite d'adresses consécutives de lecture dans la mémoire morte, et se répétant périodiquement par une boucle infinie, la période de ces codes d'instruction étant choisie inférieure ou égale à la période minimale de rafraîchissement.

Les particularités et avantages de l'invention seront mieux compris à la lecture de la description qui suit, donnée à titre d'exemple, et illustrée des figures qui représentent:

—la figure 1, un diagramme général d'une réalisation du système selon l'invention;

—la figure 2, un diagramme relatif au fonctionnement du système représenté figure 1;

—les figures 3A à 3G, des formes d'ondes relatives au fonctionnement du système représenté figure 2;

—la figure 4, un diagramme d'une réalisation du système selon l'invention dans le cadre d'une utilisation pour un enregistreur de perturbations;

—les figures 5A à 5D, des formes d'ondes relatives au fonctionnement de la réalisation représentée figure 4.

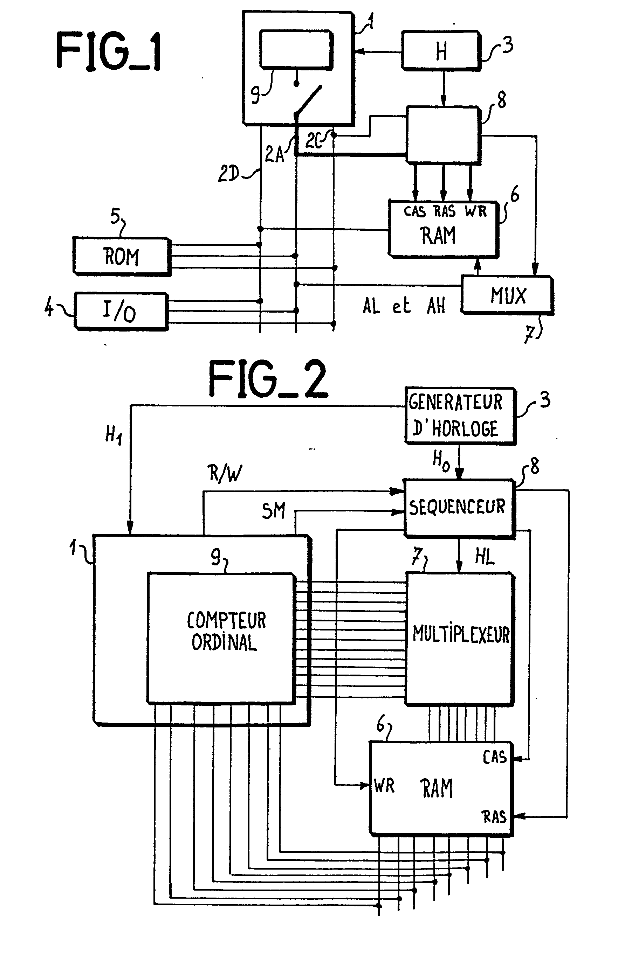

En référence à la figure 1 le microprocesseur 1 comporte un compteur ordinal 9 et est piloté par un générateur d'horloge 3. Il est relié aux autres circuits du système par l'intermédiaire de trois bus: un bus d'adresses 2A, un bus de commande 2C, et un bus de données 2D. Les différents circuits sont un circuit d'interfaces entrée-sortie 4, une mémoire morte 5 du type ROM contenant le programme du microprocesseur, une mémoire vive 6 du type RAM dynamique. La commande de cette mémoire vive est assurée par un multiplexeur d'adresses 7 commandé par un séquenceur 8. Ce dernier est lui-même piloté par le microprocesseur et le générateur d'horloge 3.

Le trait fort symbolise la liaison qui, selon l'invention, relie la sortie du compteur ordinal 9, à la mémoire vive dynamique 6 par l'intermédiaire du bus d'adresses 2A et du multiplexeur 8. Cette liaison est active lors d'un accès à la mémoire morte.

Le fonctionnement du système est maintenant décrit en référence à la figure 2. Le microprocesseur est représenté seulement avec son compteur ordinal.

Pour adresser une cellule mémoire, le microprocesseur, par l'intermédiaire du multiplexeur, fournit successivement sur les entrées adresses de la mémoire vive 6 une adresse de rangée, puis une adresse de colonne. Ces adresses sont prises en compte par la mémoire sur l'ordre de signaux d'échantillonnage de l'adresse de rangée RAS et de l'adresse de colonne CAS. L'opération effectuée sera une lecture ou une écriture en fonction de l'état d'un signal d'écriture ou de lecture R/W fourni par le microprocesseur au séquenceur 6. Ce dernier commande la mémoire vive par un signal d'écriture-lecture WR, les signaux d'échantillonnage des adresses RAS et CAS, ainsi qu'un signal de commande HL du multiplexeur. Ces signaux sont élaborés à partir d'un signal d'horloge HO et des signaux fournis par le microprocesseur.

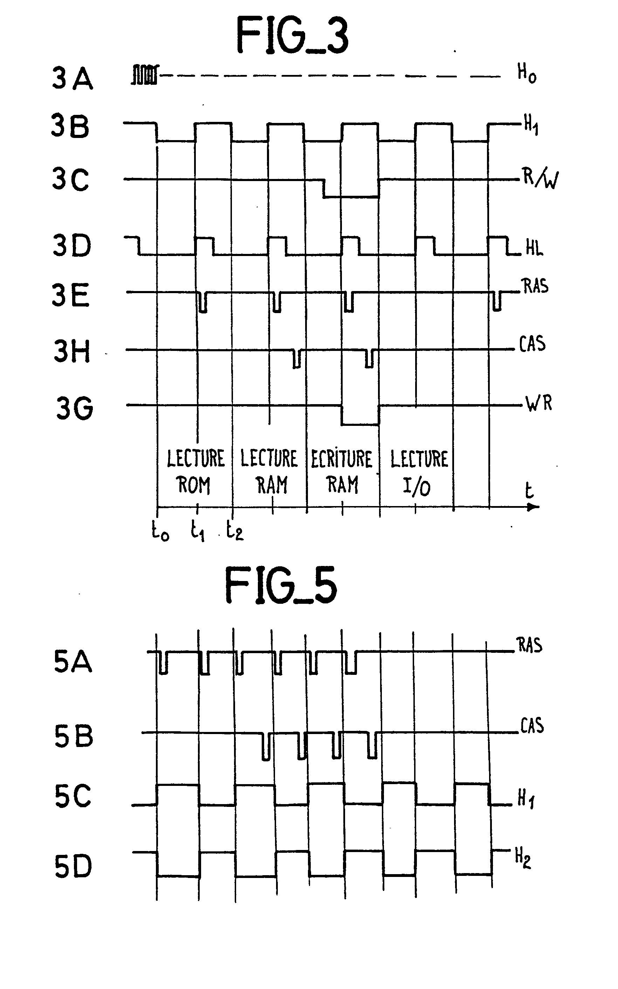

Les figures 3A à 3G représentent les différents signaux à des instants correspondant à différents types d'opérations du microprocesseur: lecture de la mémoire morte 5, lecture de la mémoire vive 6, écriture en mémoire vive et accès du circuit d'entrée-sortie 4.

La figure 3A représente le signal de fréquence d'horloge Ho ou fréquence de bits.

Le signal de fréquence de fonctionnement H1 de la figure 3B, représente le cycle élémentaire du microprocesseur. Sa fréquence est un sous-multiple de la fréquence d'horloge Ho. Il partage chaque cycle en deux moitiés. La première est réservée à la sélection du circuit à brancher (RAM, ROM...) la deuxième aux opérations à effectuer.

Sur la figure 3C, le signal R/W, fourni par le microprocesseur, indique si le cycle est un cycle de lecture ou d'écriture (signal haut pour lecture, signal bas pour l'écriture). Pour un cycle donné ce signal est déclenché pendant la première moitié de ce cycle.

La figure 3D représente le signal HL de commande du multiplexeur 7. Pendant la deuxième moitié du cycle et lorsque le signal est au niveau haut, le multiplexeur envoie à la mémoire vive 6 les adresses de poids faible AL. Inversement, lorsque le signal est au niveau bas, la mémoire vive reçoit les adresses de poids fort AH.

Sur la figure 3E, le signal RAS est le signal d'échantillonnage de l'adresse de rangée. Sur la figure 3F est représenté le signal d'échantillonnage de l'adresse de colonne. Ces impulsions d'échantillonnage se situent dans la deuxième moitié du cycle, au début pour les adresses de rangées à la fin pour les adresses de colonnes, en synchronisme avec.le signal HL.

Enfin, la figure 3G le signal représenté est le signal WR fourni par le multiplexeur indiquant, sur la base du signal R/W si le cycle est un cycle de lecture ou d'écriture (signal haut pour lecture, signal bas pour écriture) ceci toujours dans la deuxième moitié du cycle.

Le premier cycle des figures 3A à 3G (t0 à t2) est relatif à une période de lecture de la mémoire morte (lecture ROM) pour lire une instruction du programme. Seul le signal RAS est activé dans la deuxième partie de ce cycle (t1 à t2), ce qui provoque un rafraîchissement de la mémoire (cycle I). Dans les deuxième et troisième cycles lecture RAM (t2 à t3), écriture RAM (t3 à t4), les signaux RAS et CAS sont activés successivement, en synchronisme avec le signal HL; l'ordre d'écriture WR est émis dans le troisième cycle. Enfin, pour le quatrième cycle, les signaux adresses rangée et colonne RAS et CAS restent au niveau haut inactif.

Le microprocesseur 1 effectue une lecture des différents codes d'instruction placés en mémoire morte 5. Ces codes sont adressés par le compteur ordinal du microprocesseur qui est automatiquement incrémenté à chaque pas d'instruction et qui, selon l'invention sert de compteur de rafraîchissement. Le rafraîchissement de la mémoire vive 6 est obtenu lors de chaque cycle de lecture de la mémoire morte 5. L'adresse de la rangée rafraîchie est alors donnée par l'adresse de l'instruction lue. Pour que le rafraîchissement soit correct, le programme du microprocesseur devra être écrit de telle manière que les $2^n$ adresses de rangée soient balayées au rythme minimal imposé par la mémoire dynamique. Il suffit pour cela de réaliser un sous-programme comprenant $2^n$ codes d'instruction successifs et de faire exécuter cette séquence périodiquement, soit par une boucle infinie, soit par interruption.

Le rafraîchissement de la mémoire vive ne nécessitant que les adresses de rangée, si l'on dispose de 2n bits d'adresses, les n premiers bits, appelés bits de poids faible, sont utilisés pour représenter les adresses des rangées. Les n derniers bits, dits de poids fort, sont utilisés pour représenter les adresses des colonnes.

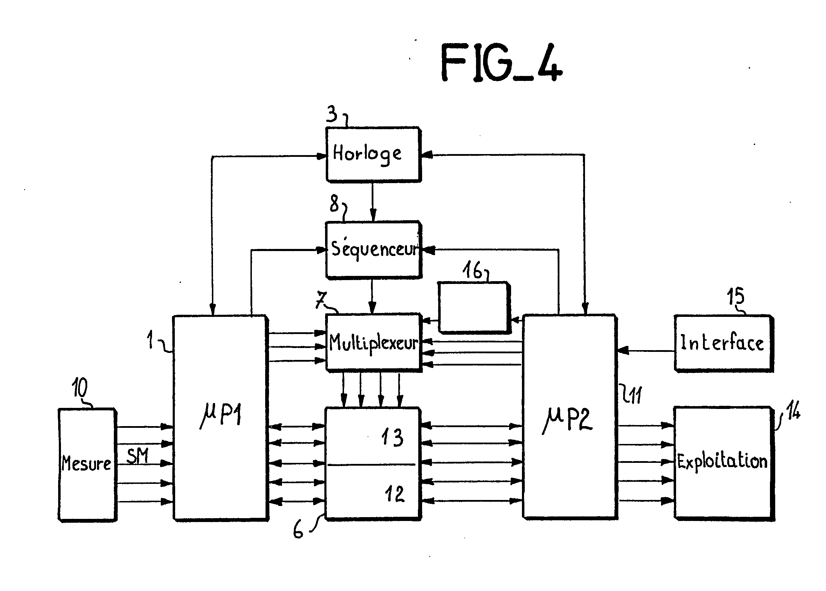

Les applications de l'invention sont possibles dans des systèmes dont le logiciel prévoit une séquence de au moins $2^n$ instructions successives (au moins toutes les 2 millisecondes); en particulier, les appareils effectuant des surveillances permanentes de valeurs. Une application possible de ce système est celle à un enregistreur de perturbations (voir figure 4).

Ce dernier est un appareil qui assure une surveillance permanente de grandeurs analogiques et logiques. Les signaux de mesure SM issus d'un perturbographe 10 sont échantillonnés, après numérisation, par un premier microprocesseur 1 et stockés dans une mémoire de prédéclenchement 12.

Lorsque l'on veut visualiser ou exploiter les signaux de mesure SM, on transfère le contenu de la mémoire de prédéclenchement 12 dans une mémoire tampon 13 de grande capacité, sur ordre de déclenchement interne ou externe. Cet ordre peut être donné soit manuellement, soit par un circuit externe au système, par exemple un circuit d'interface 15, ou par des circuits de surveillance, par exemple un comparateur à seuil détectant les fortes intensités de courant.

L'enregistrement dans la mémoire tampon 12 se poursuit ensuite pendant une durée prédéterminée. Ainsi, les états des signaux d'entrée avant, pendant et après l'ordre de déclenchement sont mémorisés et peuvent être restitués sur papier par un dispositif d'impression graphique 14.

Pour remplir cette fonction, il est commode de disposer de deux microprocesseurs: le premier 1 assure la fonction de surveillance (échantillonnage, numérisation et rangement dans la mémoire de prédéclenchement), le deuxième 11 gère les enregistrements (rangement dans la mémoire tampon, commande du dispositif d'impression).

Etant donné le volume important de données à échanger entre les deux microprocesseurs, l'utilisation d'une mémoire dynamique 6 commune aux deux microprocesseurs s'impose. Le rafraîchissement de cette mémoire est assuré par le programme d'échantillonnage des entrées exécuté cycliquement par le premier microprocesseur 1.

En se reportant aux figures 5A à 5D, on constate que les signaux de fréquences de fonctionnement H1 et H2 des deux microprocesseurs sont en opposition. De ce fait, pendant que le premier des microprocesseurs est dans la première moitié d'un cycle (sélection du circuit), le deuxième est dans la deuxième moitié du cycle (prise en compte des adresses rangée et de colonne. Ainsi la mémoire vive est utilisée en alternance, soit pour l'un, soit pour l'autre des microprocesseurs.

Si on dispose d'une mémoire de 64K octets, 16K octets peuvent être utilisés par les deux microprocesseurs, les 48K octets restants constituant la mémoire tampon et étant utilisés seulement par le deuxième microprocesseur 11.

Dans le cas où la capacité d'adressage du deuxième microprocesseur 11 est inférieure à la taille de la mémoire tampon, on procède par une sélection dite "par page", les bits d'adresse supplémentaires sont fournis par un registre 16 commandé par le deuxième microprocesseur.

**Revendications**

1. Système informatique comportant au moins, un microprocesseur (1) avec un compteur ordinal (9) pour l'adressage d'une mémoire morte (5) contenant le programme, une mémoire vive (6) du type dynamique nécessitant des rafraîchissements, et un multiplexeur (7) des adresses de ladite mémoire vive, les adresses de rafraîchissement étant issues du compteur ordinal et appliquées à la mémoire vive dynamique, par l'intermédiaire du multiplexeur, caractérisé en ce que le programme comporte une suite de codes d'instruction correspondant à une suite d'adresses consécutives de lecture dans la mémoire morte, et se répétant périodiquement par une boucle infinie, la période de ces codes d'instruction étant choisie inférieure ou égale à la période minimale de rafraîchissement.

2. Système selon la revendication 1, caractérisé en ce qu'un séquenceur (8) commandé par le microprocesseur est utilisé pour commander la mémoire vive (6) par des signaux de commande d'écriture ou de lecture (WR), des signaux d'échantillonage de l'adresse de rangée (RAS) et d'échantillonnage de l'adresse de colonne (CAS), le séquenceur commandant le multiplexeur (7) par un signal de commande du multiplexeur (HL).

3. Système selon la revendication 2, caractérisée en ce que les premiers bits d'adresse dits bits d'adresse de poids faible donnent l'adresse de rangée (RAS), et en ce que les derniers bits d'adresse dits bits d'adresse de poids fort donnent l'adresse de colonne (CAS).

4. Système selon la revendication 2 ou 3, caractérisé en ce qu'un générateur d'horloge (3) délivre un signal de fréquence de bits (HO) au séquenceur (8) et un signal de fréquence de fonctionnement (HI) au microprocesseur (1).

5. Système selon l'une quelconque des revendications précédentes, caractérisé en ce qu'il comprend un deuxième microprocesseur (11) ayant accès à la mémoire vive dynamique (6) en alternance avec le premier microprocesseur (1).

6. Système selon les revendications 4 et 5, caractérisé en ce que le générateur d'horloge (3) délivre au séquenceur (8) un signal de fréquence de fonctionnement (H2) du deuxième microcesseur (11) en opposition avec le signal de fréquence de fonctionnement (H1) du premier microprocesseur (1) de sorte que la mémoire vie dynamique (6) est accessible pour l'un des deux microprocesseurs pendant la première moitié de cycle élémentaire, et est accessible à l'autre pendant la deuxième moitié de cycle.

7. Système selon la revendication 6, caractérisé en ce que le microprocesseur (1) est utilisé pour assurer la fonction surveillance de grandeurs en échantillonnant des grandeurs mesurées et en les mémorisant dans une mémoire de prédéclenchement constituée par une première zone (11) de la mémoire vive dynamique (6), un deuxième microprocesseur (11) étant utilisé pour gérer les enregistrements des mesures en vue de les exploiter en les mémorisant dans une deuxième zone (12) de la mémoire dynamique, le rafraîchissement de la mémoire étant assuré par le premier microprocesseur.

8. Système selon l'une quelconque des revendications 5, 6, 7, caractérisé en ce que la capacité de la mémoire vive dynamique (6) étant supérieure à la capacité d'adressage du deuxième microprocesseur (11) ce dernier commande un registre (16) qui fournit les bits supplémentaires d'adresse.

9. Système selon l'une quelconque des revendications précédentes, caracatérisé en ce qu'il est utilisé dans un système enregistreur de perturbations.

**Patentansprüche**

1. Informationssystem mit zumindest einem Mikroprozessor (1) mit einem Zuordnungszähler (9), um einen statischen Speicher (5), der das Programm enthält, adressieren zu können, mit einem dynamischen Speicher (6), der Auffrischungen benötigt, und einem Multiplexer (7) für die Adressen des dynamischen Speichers, wobei die Adressen für die Auffrischung vom Zuordnungszähler kommen und mittels des Multiplexers auf den dynamischen Speicher angewandt werden, dadurch gekennzeichnet, daß das Programm eine Reihe von Instruktionscodes aufweist, die eine Reihe aufeinanderfolgender, im statischen Speicher zu lesende Adressen enthält, und durch eine unendliche Schleife periodisch wiederholt wird, wobei die Periode dieser Instruktionscodes kleiner oder gleich der minimalen Auffrischungszeit gewählt wird.

2. System nach Anspruch 1, dadurch gekennzeichnet, daß ein Sequenzglied (8), das durch den Mikroprozessor gesteuert wird, verwendet wird, um den dynamischen Speicher (6) mit Befehlssignalen zum Schreiben oder Lesen (WR), mit Zeilenauffrischungssignalen (RAS) und Spaltenauffrischungssignalen (CAS) zu versorgen, wobei das Sequenzelement den Multiplexer (7) mit einem Multiplexer-Befehlssignal (HL) ansteuert.

3. System nach Anspruch 2, dadurch gekennzeichnet, daß die ersten Adressenbits, genannt niedrigstellige Adressenbits, die Zeilenadresse (RAS) angeben, und daß die letzten Adressenbits, genannt hochstellige Adressenbits, die Spaltenadresse (CAS) angeben.

4. System nach Anspruch 2 oder 3, dadurch gekennzeichnet, daß ein Taktgeber (3) ein bit-Frequenzsignal (HO) an das Sequenzelement (8) und ein Funktions-Frequenzsignal (HI) an den Mikroprozessor (1) gibt.

5. System nach einem der vorstehenden Ansprüche, dadurch gekennzeichnet, daß es einen zweiten Mikroprozessor (11) aufweist, der, alternierend zum ersten Mikroprozessor (1), Zugang zum RAM-Speicher (6) hat.

6. System nach den Ansprüchen 4 und 5, dadurch gekennzeichnet, daß der Taktgeber (3) an das Sequenzelement (8) ein Funktionsfrequenzsignal (H2) des zweiten Mikroprozessors (11) entgegengesetzt zum Funktionsfrequenzsignal (H1) des ersten Mikroprozessors (1) abgibt, so, daß der dynamische Speicher (6) während der ersten Hälfte des Elementarzyklus für einen der beiden Mikroprozessoren und während der zweiten Hälfte des Zyklus für den anderen zugänglich ist.

7. System nach Anspruch 6, dadurch gekennzeichnet, daß der Mikroprozessor (1) verwendet wird, um die Überwachungsfunktion durch das Ziehen von Proben gemessener Größen sicherzustellen und sie in einem Vorauslösespeicher, der aus einer ersten Zone (11) des dynamischen Speichers (6) gebildet wird, abspeichert, wobei ein zweiter Mikroprozessor (11) verwendet wird, um die Abspeicherungen der Messungen in Hinblick auf ihre Verwendung in einer zweiten Zone (12) des dynamischen Speichers zu bewirken, wobei die Auffrischung des Speichers vom ersten Mikroprozessors sichergestellt wird.

8. System nach einem der Ansprüche 5, 6, 7, dadurch gekennzeichnet, daß die Kapazität des dynamischen Speichers (6) größer ist als die Adressenkapazität des zweiten Mikroprozessors (11), wobei letzterer ein Register (11) ansteuert, das die zusätzlichen Adressenbits zur Verfügung stellt.

9. System nach einem der vorstehenden Ansprüche, dadurch gekennzeichnet, daß es in einem Störungsaufzeichnungsgerät verwendet wird.

**Claims**

1. Data processing system comprising at least, a microprocessor (1) with an ordinal counter (9) for addressing a ROM memory (5) containing the program, a dynamic type RAM memory requiring refreshments, and, a multiplexer (7) for the addresses in said RAM memory, the refreshing addresses being outputted by the ordinal counter and applied to the dynamic RAM memory via the multiplexer, characterized in that the program comprises a sequence of instruction codes corresponding to a sequence of consecutive reading addresses in the ROM memory, being periodically repeated by an indefinite loop, the period of said instruction codes being so selected as to be less than or equal to the minimum refreshment period.

2. System according to claim 1, characterized in that a sequencer (8) controlled by the microprocessor is used for controlling the RAM memory (6) by means of writing or reading control signals (WR), signals for sampling the row address (RTAS) and for sampling the column address (CAS), the sequencer controlling the multiplexer (7) by means of a multiplexer control signal (HL).

3. System according to claim 2, characterized in that the first address bits, called low weight address bits, give the row address (RAS) and in that the last address bits, called high weight address bits, give the column address (CAS).

4. System according to claim 2 or 3, characterized in that a clock generator (3) delivers to the sequencer (8) a bit frequency signal (HO) and an operating frequency signal (H1) to microprocessor (1).

5. System according to any one of the preceding claims, characterized in that it comprises a second microprocessor (11) having access to the dynamic RAM memory (6) alternately with the first microprocessor (1).

6. System according to claims 4 and 5, characterized in that the clock generator (3) delivers to the sequence (8) an operating frequency signal (H2) of the second microprocessor (11) in opposition with the operating frequency signal (H1) of the first microprocessor (1) so that the dynamic RAM memory (6) is accessible for one of the two microprocessors during the first elementary half cycle, and is accessible to the other during the second half cycle.

7. System according to claim 6, characterized in that the microprocessor (1) is used for providing the magnitude monitoring function by sampling the magnitudes measured and storing them in a preinitiation memory formed by a first zone (11) of the dynamic RAM memory (6), a second microprocessor (11) being used for controlling the recordings of the measurements for using them by storing them in a second zone (12) of the dynamic memory, refreshing of the memory being provided by the first microprocessor.

8. System according to any one of claims 5, 6, 7, characterized in that the capacity of the dynamic RAM memory (6) is greater than the addressing capacity of the second microprocessor (11), this latter controls a register (16) which supplies the additional address bits.

9. System according to any one of the preceding claims, characterized in that it is used as a disturbance recording system.

FIG_1

FIG_2

EP 0 156 722 B1

FIG_3

FIG_5

# FIG_4

EP 0 156 722 B1